# EUROPÄISCHE PATENTSCHRIFT

(11) **EP 1 147 608 B1**
(45) Veröffentlichungstag und Bekanntmachung des Hinweises auf die Patenterteilung: **30.03.2005**
(21) Anmeldenummer: 99965388.4
(22) Anmeldetag: 01.12.1999
(51) Int. Cl.: H03K 19/003

(54) **VORRICHTUNG ZUR VERRINGERUNG DER ELEKTROMAGNETISCHEN EMISSION BEI INTEGRIERTEN SCHALTUNGEN MIT TREIBERSTUFEN**
DEVICE FOR REDUCING ELECTROMAGNETIC EMISSION IN INTEGRATED CIRCUITS PROVIDED WITH DRIVER STAGES
DISPOSITIF PERMETTANT DE REDUIRE L'EMISSION ELECTROMAGNETIQUE DANS LE CAS DE CIRCUITS INTEGRES DOTES D'ETAGES D'ATTAQUE

(30) Priorität: 01.12.1998 DE 19855445
(43) Veröffentlichungstag der Anmeldung: 24.10.2001
(73) Patentinhaber: Infineon Technologies AG, 81669 München (DE)
(72) Erfinder: EICHFELD, Herbert, D-80538 München (DE); RÖMER, Dirk, D-80637 München (DE)
(74) Vertreter: Viering, Jentschura & Partner
(86) Internationale Anmeldenummer: PCT/DE1999/003821
(87) Internationale Veröffentlichungsnummer: WO 2000/033463

(56) Entgegenhaltungen:
- DE-A- 19 700 988
- US-A- 4 783 603
- US-A- 5 654 929
- PATENT ABSTRACTS OF JAPAN vol. 013, no. 338 (E-795), 28. Juli 1989 (1989-07-28) -& JP 01 098317 A (NEC CORP), 17. April 1989 (1989-04-17)
- REISS K. ET AL: 'Integrierte Digitalbausteine Kleines Praktikum', 1970, SIEMENS AKTIENGESELLSCHAFT, BERLIN MÜNCHEN

## Beschreibung

Vorrichtung zur Verringerung der elektromagnetischen Emission bei integrierten Schaltungen mit Treiberstufen.

Die Erfindung betrifft eine integrierte Schaltung mit einer Mehrzahl von Treiberstufen, bei der durch Blockkondensatoren eine elektromagnetische Emission (EME) durch Schaltvorgänge der Treiber auf die Versorgungsspannungsleitungen unterdrückt wird.

Um die elektromagnetische Emission integrierter Schaltungen zu reduzieren, werden große on-chip-Kapazitäten in der Größenordnung von beispielsweise 1 bis 10 nF integriert. Diese Blockkapazitäten dienen zur Beruhigung der Versorgungsspannungen bzw. als Energiereserve, insbesondere für starke Treiber. Ihre Wirkung ist umso besser, je größer die Kapazitäten sind bzw. je niederohmiger sie angeschlossen werden. Es wird deshalb möglichst jede freie Chipfläche eines Halbleiterbauelements zur Bildung dieser Blockkapazitäten genutzt. Eine Vergrößerung dieser Blockkondensatoren durch eine größere Chipfläche aber auch durch dünnere oder besondere Dielektrika bedeuten einen höheren Kostenaufwand. Hinzu kommt, daß durch immer bessere Designwerkzeuge immer kompaktere Layouts entstehen, was immer weniger freie Flächen für derartige Blockkapazitäten bedeutet.

Die Verwendung von Blockkondensatoren bei integrierten Schattungen mit Treiberstufen ist aus den Dokumenten US-A-5 654 929 und US-A-4 783 603 bekannt.

Die der Erfindung zugrundeliegende Aufgabe besteht nun darin, eine Vorrichtung zur Verringerung der elektromagnetischen Emission bei integrierten Schaltungen mit einer Mehrzahl von Treiberstufen anzugeben, bei der eine Verringerung der elektromagnetischen Emission möglichst ohne eine Vergrößerung der Kapazität der Blockkondensatoren erreicht wird.

Diese Aufgabe wird erfindungsgemäß durch die Merkmale der Patentansprüche 1,2 oder 3 gelöst. Anspruch 4 betrifft eine verteilhafte Ausgestaltung der Erfindung.

Die Erfindung wird anhand von in der Zeichnung dargestellten Ausführungsbeispielen näher erläutert. Dabei zeigt
- Figur 1: ein Blockschaltbild mit mehreren Treibergruppen und Blockkondensatoreinheiten,
- Figur 2: ein detaillierteres Blockschaltbild mit einer einzelnen Treibergruppe und einer einzelnen Blockkondensatoreinheit und
- Figur 3 bis 5: drei verschiedene Varianten der Blockkondensatoreinheit von Figur 2.

Die Erfindung geht im wesentlichen davon aus, daß in der Regel nicht alle starken Treiber eines Bausteins gleichzeitig schalten. Treiber mit unterschiedlichen Schaltzeitpunkten im Verarbeitungszyklus eines Bausteins werden zu einer Treibergruppe zusammengefaßt und gemeinsam von einer Blockkapazität versorgt, die den größten Ladungsbedarf dieser Treibergruppe gerade liefern kann. Darüber hinaus werden seltene Spitzenlastfälle durch eine Spannungssteuerung oder Spannungsregelung der lokalen Versorgungsspannungen kompensiert und die Blockkapazität kann aufgrund dessen geringer ausgelegt sein.

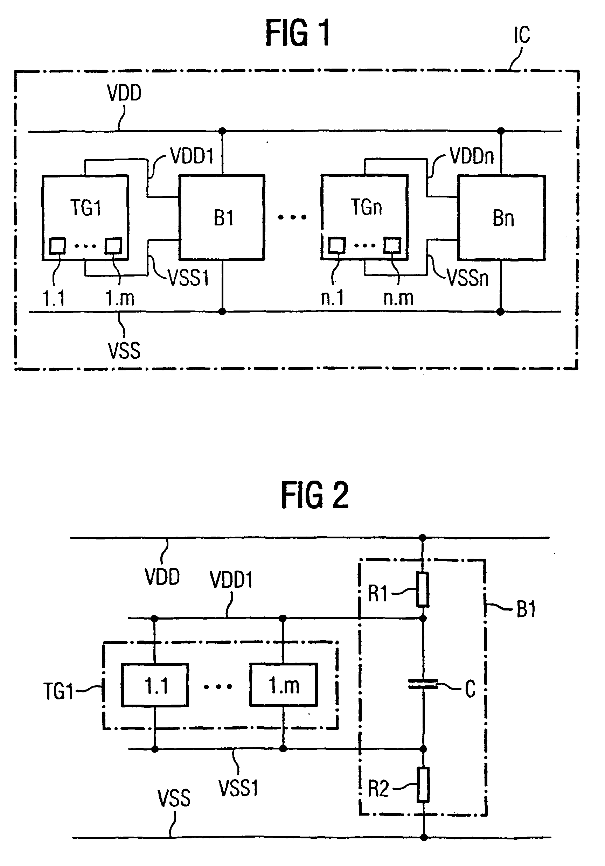

In Figur 1 ist eine integrierte Schaltung IC mit globalen Versorgungsspannungsleitungen VDD und VSS dargestellt. Die integrierte Schaltung IC kann auch mehrere als zwei globale Versorgungsspannungsleitungen aufweisen. Über jeweilige Abblockeinheiten B1 ... Bn, die gemeinsam über die globalen Versorgungsspannungsleitungen versorgt werden, werden über jeweilige lokale Versorgungsspannungsleitungen VDD1 und VSS1 ... VDDn und VSSn jeweilige Treibergruppen TG1 und TGn versorgt. Die beispielhaft dargestellte Treibergruppe TG1 enthält dabei Treiber 1.1 ... 1.m und eine beispielhaft dargestellte Treibergruppe TGn enthält Treiber n.1 ... n.m, wobei in jeder Treibergruppe zumindest alle Treiber mit großem Strombedarf zu unterschiedlichen Zeiten schalten.

In Figur 2 ist eine Treibergruppe TG1 und eine Abblockeinheit B1 detaillierter dargestellt. Alle Treiber 1.1 ... 1.m der Treibergruppe TG1 sind über eine lokale Versorgungsspannungsleitung VDD1 mit einem ersten Anschluß eines Blockkondensators C und über die lokale Versorgungsspannungsleitung VSS1 mit einem zweiten Anschluß des Blockkondensators C verbunden. Die Abblockeinheit B1 weist neben dem Blockkondensator noch einen Widerstand R1 und einen Widerstand R2 auf, wobei der Widerstand R1 den ersten Anschluß des Blockkondensators C mit der globalen Versorgungsspannung VDD und der Widerstand R2 den zweiten Anschluß des Blockkondensators C mit der globalen Versorgungsspannungsleitung VSS verbindet. Die Widerstände R1 und R2 sind dabei im allgemeinen gleich groß. Die Dimensionierung der Widerstände und des Kondensators hängen von der zulässigen Versorgungsspannungsschwankung auf den lokalen Versorgungsleitungen VDD1 und VSS1 ab. Mit dieser RC-Anordnung werden hochfrequente Störungen von der globalen Versorgung ferngehalten. Dies gelingt umso besser, je größer die Widerstände R1 und R2 dimensioniert sind.

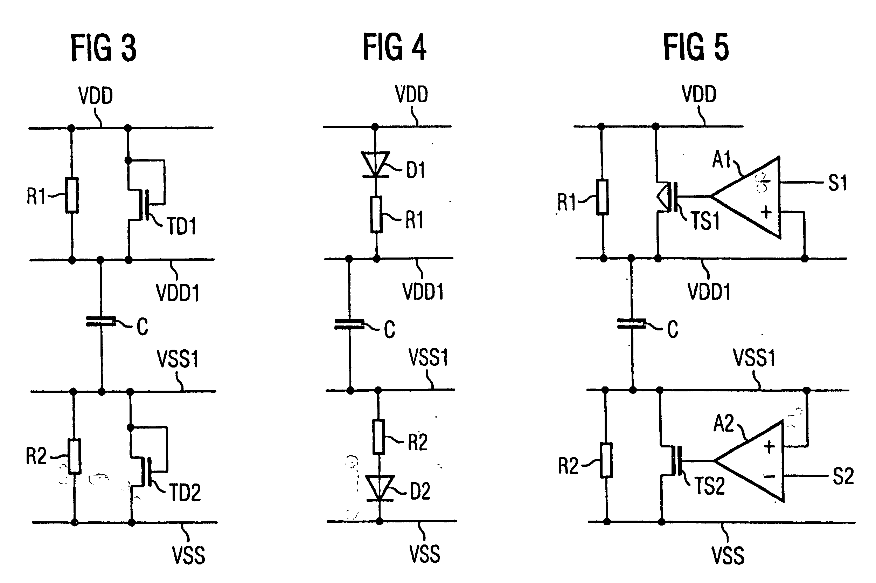

In Figur 3, 4 und 5 sind erfindungsgemäße Ausführungsformen der Abblockeinheit B1 dargestellt, die durch eine zusätzliche Spannungssteuerung bzw. -regelung eine Verkleinerung der Kapazität des Blockkondensators C erlauben.

In Figur 3 ist parallel zum Widerstand R1 und / oder zum Widerstand R2 jeweils ein als Diode geschalteter MOS-Transistor TD1 und TD2 geschaltet. Die als Diode geschalteten MOS-Transistoren können einzeln oder beide auch als gewöhnliche pn-Dioden ausgebildet sein. Darüber hinaus ist auch eine Serienschaltung entsprechender pn-Dioden oder MOS-Dioden möglich, wobei die interne Spannungsreduktion für R1 = R2 → ∞ gleich 2*n*V_{T} beträgt, wenn n die Zahl der in Serie geschalteten Dioden und V_{T} die Schwellenspannung der einzelnen Diode ist.

Desweiteren ist in Figur 4 eine weitere erfindungsgemäße Ausführungsform der der Abblockeinheit B1 dargestellt, bei der anstelle des Widerstandes R1 eine Reihenschaltung des Widerstandes R1 und einer Diode D1 und/oder anstelle des Widerstandes R2 eine Reihenschaltung des Widerstandes R2 und einer weiteren Diode D2 vorhanden. Auch bei der in Figur 4 dargestellten Serienschaltung können sowohl die pn-Dioden aber auch MOS-Dioden Verwendung finden, wobei auch hier mehrere in Serie geschaltet sein können. Durch eine exponentielle Diodenkennlinie, können Spannungseinbrüche auf der lokalen Versorgungsspannungsleitung VDD1 durch einen starken Strom über die Diode D1 schnell ausgeglichen werden und der Widerstand R1 verhindert einen zu starken Stromanstieg, der eine entsprechend starke elektromagnetische Emission bedeuten würde.

In Figur 5 ist, in einem letzten erfindungsgemäßen Ausführungsbeispiel, dem Widerstand R1 ein Stelltransistor TS1 parallel geschaltet, der über einen Regelverstärker angesteuert wird, wobei im Regelverstärker A1 die Spannung auf der lokalen Versorgungsspannungsleitung VDD1 mit einem Sollwert S1 verglichen wird. Entsprechendes gilt für den Widerstand R2, dem ein weiterer Stelltransistor TS2 parallel geschaltet ist, der seinerseits von einem weiteren Regelverstärker A2 angesteuert wird. Der Regelverstärker A2 vergleicht dabei die Spannung auf der lokalen Versorgungsleitung VSS1 mit einem weiteren Sollwert S2. Es kann aber auch nur einem der beiden Widerstände R1 und R2 ein Stelltransistor parallel geschaltet sein. Die aufwendigere Regelung bringt den Vorteil, daß der Sollwert des Spannungseinbruchs auf dem lokalen Netz einstellbar ist. Der Stelltransistor TS ist hier ein p-Kanal-Transistor und der Stelltransistor TS2 ein n-Kanal-Transistor. Sinkt die lokale Versorgungsspannung auf der Versorgungsspannungsleitung VDD1 unter den Sollwert S1, so steuert der Verstärker A1 den Stelltransistor TS1 auf und es fließt zusätzlich zu einem Strom durch den Widerstand R1 ein Strom durch den Transistor TS1. Entsprechendes gilt für den Widerstand R2 und den Transistor TS2.

## Patentansprüche

1. Vorrichtung zur Verringerung der elektromagnetischen Emission bei einer integrierten Schaltung (IC) mit einer Mehrzahl von Treiberstufen (1.1 ...n.m),
bei der die Treiberstufen derart zu Treibergruppen (TG1 ... TGn) zusammengefaßt sind, daß die Treiberstufen einer jeweiligen Treibergruppe (TG1) alle zu unterschiedlichen Zeitpunkten schalten,
bei der eine jeweilige Treibergruppe über jeweilige lokale Versorgungsleitungen (VDD1, VSS1) mit einer jeweiligen Abblockeinheit (B1) verbunden ist, die einen jeweiligen Blockkondensator (C) enthält und die mit einer ersten und zweiten globalen Versorgungsleitung (VDD, VSS) verbunden ist,
bei der die jeweilige erste lokale Versorgungsleitung über einen jeweiligen ersten Widerstand (R1) mit der ersten globalen Versorgungsleitung, die jeweils zweite lokale Versorgungsleitung (VDD) über einen jeweiligen zweiten Widerstand (R2) mit der zweiten globalen Versorgungsleitung (VSS) und die erste und die zweite lokale Versorgungsleitung über den Blockkondensator (C) verbunden ist,
bei der dem ersten und/oder dem zweiten Widerstand jeweils eine einzelne Diode oder eine Reihenschaltung von Dioden parallel geschaltet ist, wobei eine Diode eine pn-Diode (D) oder ein als Diode geschalteter MOS-Transistor ist.

2. Vorrichtung zur Verringerung der elektromagnetischen Emission bei einer integrierten Schaltung (IC) mit einer Mehrzahl von Treiberstufen (1.1 ...n.m),
bei der die Treiberstufen derart zu Treibergruppen (TG1 ... TGn) zusammengefaßt sind, daß die Treiberstufen einer jeweiligen Treibergruppe (TG1) alle zu unterschiedlichen Zeitpunkten schalten,
bei der eine jeweilige Treibergruppe über jeweilige lokale Versorgungsleitungen (VDD1, VSS1) mit einer jeweiligen Abblockeinheit (B1) verbunden ist, die einen jeweiligen Blockkondensator (C) enthält und die mit einer ersten und zweiten globalen Versorgungsleitung (VDD, VSS) verbunden ist,
bei der die jeweilige erste lokale Versorgungsleitung über einen jeweiligen ersten Widerstand (R1) mit der ersten globalen Versorgungsleitung, die jeweils zweite lokale Versorgungsleitung (VDD) über einen jeweiligen zweiten Widerstand (R2) mit der zweiten globalen Versorgungsleitung (VSS) und die erste und die zweite lokale Versorgungsleitung über den Blockkondensator (C) verbunden ist,
bei der dem ersten (R1) und/oder zweiten Widerstand (R2) jeweils eine Diode oder eine Reihenschaltung von Dioden derart in Reihe geschaltet ist, daß die jeweilige lokale erste Versorgungsleitung über die Diode und den jeweiligen ersten Widerstand mit der ersten globalen Versorgungsleitung (VDD) verbunden ist und/oder daß die jeweilige lokale zweite Versorgungsleitung über eine Diode und dem jeweiligen zweiten Widerstand mit der zweiten globalen Versorgungsleitung (VSS) verbunden ist, wobei die jeweilige Diode eine pn-Diode (D) oder ein als Diode geschalteter MOS-Transistor ist.

3. Vorrichtung zur Verringerung der elektromagnetischen Emission bei einer integrierten Schaltung (IC) mit einer Mehrzahl von Treiberstufen (1.1 ...n.m),
bei der die Treiberstufen derart zu Treibergruppen (TG1 ... TGn) zusammengefaßt sind, daß die Treiberstufen einer jeweiligen Treibergruppe (TG1) alle zu unterschiedlichen Zeitpunkten schalten,
bei der eine jeweilige Treibergruppe über jeweilige lokale. Versorgungsleitungen (VDD1, VSS1) mit einer jeweiligen Abblockeinheit (B1) verbunden ist, die einen jeweiligen Blockkondensator (C) enthält und die mit einer ersten und zweiten globalen Versorgungsleitung (VDD, VSS) verbunden ist,
bei der die jeweilige erste lokale Versorgungsleitung über einen jeweiligen ersten Widerstand (R1) mit der ersten globalen Versorgungsleitung, die jeweils zweite lokale Versorgungsleitung (VDD) über einen jeweiligen zweiten Widerstand (R2) mit der zweiten globalen Versorgungsleitung (VSS) und die erste und die zweite lokale Versorgungsleitung über den Blockkondensator (C) verbunden ist,
bei der dem ersten und/oder zweiten Widerstand ein jeweiliger Stelltransistor (TS1, TS2) parallel geschaltet ist, der durch einen Regelverstärker (A1, A2) derart angesteuert ist, daß er leitend wird, wenn der Betrag des Spannungswertes der jeweiligen lokalen Versorgungsleitung kleiner als der Betrag des jeweiligen Sollwertes (S1, S2) ist.

4. Vorrichtung nach einem der Ansprüche 1 bis 3,
bei der der jeweilige Blockkondensator (C) aus einer Parallelschaltung einer Mehrzahl von Einzelkondensatoren besteht, die auf freie Flächen der integrierten Schaltung verteilt sind.

## Claims

1. A device for reducing the electromagnetic emission in an integrated circuit (IC) having a plurality of driver stages (1.1 ... n.m),
in which the driver stages are combined to form driver groups (TG1 ... TGn) in such a way that the driver stages of a respective driver group (TG1) all switch at different instants,
in which a respective driver group is connected via respective local supply lines (VDD1, VSS1) to a respective blocking unit (B1), which contains a respective blocking capacitor (C) and is connected to a first and second global supply line (VDD, VSS),
in which the respective first local supply line is connected via a respective first resistor (R1) to the first global supply line, the respective second local supply line (VDD) is connected via a respective second resistor (R2) to the second global supply line (VSS), and the first and the second local supply lines are connected via the blocking capacitor (C),
in which an individual diode or a series circuit of diodes is in each case connected in parallel with the first and/or the second resistor, a diode being a pn diode (D) or a MOS transistor connected as a diode.

2. A device for reducing the electromagnetic emission in an integrated circuit (IC) having a plurality of driver stages (1.1 ... n.m),
in which the driver stages are combined to form driver groups (TG1 ... TGn) in such a way that the driver stages of a respective driver group (TG1) all switch at different instants,
in which a respective driver group is connected via respective local supply lines (VDD1, VSS1) to a respective blocking unit (B1), which contains a respective blocking capacitor (C) and is connected to a first and second global supply line (VDD, VSS),
in which the respective first local supply line is connected via a respective first resistor (R1) to the first global supply line, the respective second local supply line (VDD) is connected via a respective second resistor (R2) to the second global supply line (VSS), and the first and the second local supply lines are connected via the blocking capacitor (C),
in which a diode or a series circuit of diodes is in each case connected in series with the first (R1) and/or second resistor (R2) in such a way that the respective local first supply line is connected to the first global supply line (VDD) via the diode and the respective first resistor, and/or that the respective local second supply line is connected to the second global supply line (BSS) via a diode and the respective second resistor, the respective diode being a pn diode (D) or a MOS transistor connected as a diode.

3. A device for reducing the electromagnetic emission in an integrated circuit (IC) having a plurality of driver stages (1.1 ... n.m),
in which the driver stages are combined to form driver groups (TG1 ... TGn) in such a way that the driver stages of a respective driver group (TG1) all switch at different instants,
in which a respective driver group is connected via respective local supply lines (VDD1, VSS1) to a respective blocking unit (B1), which contains a respective blocking capacitor (C) and is connected to a first and second global supply line (VDD, VSS),
in which the respective first local supply line is connected via a respective first resistor (R1) to the first global supply line, the respective second local supply line (VDD) is connected via a respective second resistor (R2) to the second global supply line (VSS), and the first and the second local supply lines are connected via the blocking capacitor (C),
in which a respective actuating transistor (TS1, TS2) is connected in parallel with the first and/or second resistor, which transistor is driven by a regulating amplifier (A1, A2) in such a way that it is turned on if the magnitude of the voltage value of the respective local supply line is less than the magnitude of the respective desired value (S1, S2).

4. The device as claimed in one of claims 1 to 3,
in which the respective blocking capacitor (C) comprises a parallel circuit formed by a plurality of individual capacitors which are distributed over the free areas of the integrated circuit.

## Revendications

1. Dispositif permettant de réduire l'émission électromagnétique dans le cas d'un circuit intégré (CI) doté de plusieurs étages d'attaque (1.1, ..., n.m),
dans lequel les étages d'attaque sont réunis en groupes d'attaque (TG1, ..., TGn) de telle façon que les étages d'attaque d'un groupe d'attaque respectif (TG1) se connectent tous à des instants différents,
dans lequel un groupe d'attaque respectif est raccordé par des lignes d'alimentation locales respectives (VDD1, VSS1) à une unité de blocage respective (B1), qui comprend un condensateur de blocage respectif (C) et qui est raccordé à une première et à une deuxième ligne d'alimentation globale (VDD, VSS),
dans lequel la première ligne d'alimentation locale respective est raccordée par une première résistance respective (R1) à la première ligne d'alimentation globale, la deuxième ligne d'alimentation locale respective (VDD) est raccordée par une deuxième résistance respective (R2) à la deuxième ligne d'alimentation globale (VSS) et les première et deuxième lignes d'alimentation locales sont raccordées par le condensateur de blocage (C),
dans lequel une diode unique ou un ensemble de diodes montées en série est chaque fois monté(e) en parallèle avec la première et/ou la deuxième résistance, une diode étant une diode pn (D) ou un transistor MOS monté en diode.

2. Dispositif permettant de réduire l'émission électromagnétique dans le cas d'un circuit intégré (CI) doté de plusieurs étages d'attaque (1.1, ..., n.m),
dans lequel les étages d'attaque sont réunis en groupes d'attaque (TG1, ..., TGn) de telle façon que les étages d'attaque d'un groupe d'attaque respectif (TG1) se connectent tous à des instants différents,
dans lequel un groupe d'attaque respectif est raccordé par des lignes d'alimentation locales respectives (VDD1, VSS1) à une unité de blocage respective (B1), qui comprend un condensateur de blocage respectif (C) et qui est raccordé à une première et à une deuxième ligne d'alimentation globale (VDD, VSS),
dans lequel la première ligne d'alimentation locale respective est raccordée par une première résistance respective (R1) à la première ligne d'alimentation globale, la deuxième ligne d'alimentation locale respective (VDD) est raccordée par une deuxième résistance respective (R2) à la deuxième ligne d'alimentation globale (VSS) et les première et deuxième lignes d'alimentation locales sont raccordées par le condensateur de blocage (C),
dans lequel une diode ou en ensemble de diodes montées en série est respectivement monté(e) en série avec la première (R1) et/ou la deuxième (R2) résistance, de telle façon que la première ligne d'alimentation locale respective soit raccordée par la diode et la première résistance respective à la première ligne d'alimentation globale (VDD) et/ou que la deuxième ligne d'alimentation locale respective soit raccordée par une diode et la deuxième résistance respective à la deuxième ligne d'alimentation globale (VSS), la diode respective étant une diode pn (D) ou un transistor MOS monté en diode.

3. Dispositif permettant de réduire l'émission électromagnétique dans le cas d'un circuit intégré (CI) doté de plusieurs étages d'attaque (1.1, ..., n.m),
dans lequel les étages d'attaque sont réunis en groupes d'attaque (TG1, ..., TGn) de telle façon que les étages d'attaque d'un groupe d'attaque respectif (TG1) se connectent tous à des instants différents,
dans lequel un groupe d'attaque respectif est raccordé par des lignes d'alimentation locales respectives (VDD1, VSS1) à une unité de blocage respective (B1), qui comprend un condensateur de blocage respectif (C) et qui est raccordé à une première et à une deuxième ligne d'alimentation globale (VDD, VSS),
dans lequel la première ligne d'alimentation locale respective est raccordée par une première résistance respective (R1) à la première ligne d'alimentation globale, la deuxième ligne d'alimentation locale respective (VDD) est raccordée par une deuxième résistance respective (R2) à la deuxième ligne d'alimentation globale (VSS) et les première et deuxième lignes d'alimentation locales sont raccordées par le condensateur de blocage (C),
dans lequel un transistor de réglage respectif (TS1, TS2) est monté en parallèle avec la première et/ou la deuxième résistance, et est commandé par un amplificateur de réglage (A1, A2) de telle façon qu'il devienne conducteur lorsque le niveau de la valeur de la tension de la ligne d'alimentation locale respective est inférieur au niveau de la valeur de consigne respective (S1, S2).

4. Dispositif selon l'une quelconque des revendications 1 à 3, dans lequel le condensateur de blocage respectif (C) se compose de plusieurs condensateurs individuels montés en parallèle, qui sont répartis sur des surfaces libres du circuit intégré.
